# EUROPEAN PATENT APPLICATION

(11) **EP 4 845 379 A1**
(43) Date of publication of application: **25.11.2026**
(21) Application number: 26179148.7
(22) Date of filing: 18.05.2026
(51) Int. Cl.: H10W 72/00, H10P 72/70, H10P 72/78

(54) **NOZZLE HAVING MONOLITHICALLY INTEGRATED HEATER FOR SEMICONDUCTOR DIE PROCESSING AND METHODS OF FORMING SAME**

(30) Priority: 23.05.2025 US 202563811223 P
(71) Applicant: II-VI Delaware, Inc., Wilmington, DE 19890 (US)
(72) Inventor: Murano, Robert, Wilmington 19890 (US); Tanner, Charles D., Wilmington 19890 (US)
(74) Representative: Bosch Jehle Patentanwaltsgesellschaft mbH

(57) **Abstract**

Disclosed herein are die nozzles including a base crystalline substrate having an undoped region, a resistive heating region of the base crystalline substrate having a doped crystalline material monolithically integrated in the base substrate, one or more engagement features formed into the base substrate forming a die interface surface, and electrical contacts in electrical communication with the resistive heating region. One aspect of the present disclosure is directed to a method of manufacturing an integrated heater , the method comprising: providing a base substrate having an undoped crystalline material; monolithically integrating a resistive heating region of a doped crystalline material in the base substrate; forming one or more engagement features into the base substrate; and providing electrical contacts to the resistive heating region.

## Description

### FIELD OF THE DISCLOSURE

The subject matter of the present disclosure is directed to an element having one or more resistive heating regions monolithically integrated therein for thermal processing of semiconductor components. For example, the disclosed element can be a nozzle having one or more resistive heating regions monolithically integrated therein that can be used for high-throughput, high-density semiconductor processing. Disclosed nozzles can be used, for example, in thermal compression bonding of a semiconductor die to a host substrate or for semiconductor die testing. Applications of monolithically integrated elements disclosed herein may also be utilized for temperature sensing in applications that benefit from rapid thermal cycling and/or measurement.

### BACKGROUND OF THE DISCLOSURE

Semiconductor dies are commonly processed or tested using temperature. Throughput of the processing and testing can be limited by the thermal slew rate of the structures used to conduct heat to the semiconductor dies. For example, a semiconductor die is commonly attached to a host substrate using solder, which makes the electrical connections between contacts on the die and the host substrate.

Typically, the die has electrical contacts, such as copper pillar bumps, and are joined using solder to the host substrate. In the bonding process, there is ideally no warpage of the host substrate and/or the die. Preferably, the gap between the die and the host substrate is consistent with any other dies affixed to the host substrate, and the die is preferably not tilted relative to the host substrate. When gaps are present, due to any of these irregularities, non-contact open (NCO) failures may occur between the die and the host substrate during the attachment process.

The electrical contacts between pillar and solder bumps are becoming more densely packed, requiring increased alignment precision to make the soldered connection. The industry standard flip-chip bonding process for semiconductor dies has reached a limit regarding contact density. In general, for the flip-chip bonding process to work, the pitch between contacts needs to be greater than 50 µm. This limit is largely the result of die movement during reflow (melting and solidification) of the solder material during the soldering process. Additionally, uniformly making thermal, electrical, and mechanical connections between a large number of contacts while maintaining flatness to the substrate and other dies also requires increased precision.

Next-generation bonding technologies, such as the thermal compression bonding (TCB) process, have been developed to address some of these limitations. The TCB process is being increasingly utilized instead of mass reflow/flip-chip bonding and can provide advantages for thinner dies, tighter pitches, and a 3D stack of dies. The TCB process can also improve yields.

### SUMMARY OF THE DISCLOSURE

Disclosed herein are die nozzles with monolithically integrated heating regions. In one aspect of the disclosure a nozzle may include a base crystalline substrate having an undoped region, a resistive heating region of the base crystalline substrate having a doped crystalline material monolithically integrated in the base substrate, one or more engagement features formed into the base substrate forming a die interface surface, and electrical contacts in electrical communication with the resistive heating region. In another aspect of the disclosure, one or more engagement features includes a shoulder in a surface of a base substrate, the shoulder being recessed from the surface of a base substrate and being configured to engage a portion of a corresponding die. In another aspect of the disclosure, a die nozzle is configured as temperature sensor, where the resistive heating region has a resistance that varies with its temperature. In yet another aspect of the disclosure, one or more engagement features includes at least one vacuum channel, configured to pneumatically communicate a vacuum through a die nozzle to a portion of a die adjacent a surface of the base substrate. In another aspect of the disclosure, a base crystalline substrate comprises at least one of silicon (Si), crystalline silicon (c-Si), silicon carbide (SiC), diamond, silicon nitride, and allotropes of carbon.

Disclosed herein are die nozzles with monolithically integrated heating regions, where the resistive heating region has a coefficient of thermal expansion about the same as a coefficient of thermal expansion of a base crystalline substrate. In another aspect of the disclosure, a resistive heating region has a shape selected from a plate shape, a serpentine shape, a ring shape, a spiral shape, and a segmented shape. In one aspect of the disclosure a base substrate further includes a conductive via electrically connected to the resistive heating region. In another aspect of the disclosure, a base substrate further includes an additional substrate. In yet another aspect of the disclosure, a nozzle includes cooling channels within the substrate. In one aspect of the disclosure the cooling channels are between the resistive heating region and the die interface surface. In another aspect of the disclosure, the resistive heating region is between the cooling channels and the die interface surface. In one aspect of the disclosure, the resistive heating region is offset from the die interface surface. In another aspect of the disclosure, the offset is from about 100 microns to about 5 mm. In one aspect of the disclosure, a thermal isolation layer includes an oxide and the resistive heating region is between the thermal isolation layer and the die interface surface. In another aspect of the disclosure, the nozzle includes cooling channels between a thermal isolation layer and the resistive heating region.

Disclosed herein are methods of manufacturing a nozzle used for thermal compression bonding a semiconductor die to a host. The method comprises providing a base substrate having undoped crystalline material. The method comprises monolithically integrating a resistive heating region of doped crystalline material in the base substrate. Furthermore, the method comprises providing electrical contacts to the resistive heating region. Moreover, the method comprises forming at least one vacuum channel communicating through the base substrate.

One general aspect includes a method of manufacturing an integrated heater, the method comprising: providing a base substrate having an undoped crystalline material; monolithically integrating a resistive heating region by doping regions of the crystalline material in the base substrate; forming one or more engagement features into the base substrate; and providing electrical contacts to the resistive heating region.

In some embodiments, the engagement feature includes at least one vacuum channel.

In some embodiments, the integrated heater is integrated into a thermal compression bonding nozzle, and forming the one or more engagement features on into the base substrate comprises forming a shoulder in a surface of the base substrate, the shoulder being configured to engage against a portion of a corresponding semiconductor die.

Implementations may include one or more of the following features. The methods may include forming one or more engagement features on a surface of the base substrate. In another aspect of the disclosure, forming engagement features includes forming a shoulder in the surface of the base substrate, the shoulder configured to engage against a portion of a semiconductor die. In another aspect, forming a shoulder may include laser machining and/or chemically etching the shoulder. Forming one or more engagement features on the surface of the base substrate may include forming at least one vacuum trench partially in the surface of the base substrate, the vacuum trench is configured to communicate with at least one vacuum channel. In yet another aspect of the disclosure, at least one vacuum channel may be configured to draw a vacuum against a portion of the semiconductor die adjacent to the surface of the base substrate.

In another general aspect of the disclosure, systems used for thermal compression bonding a semiconductor die to a host are disclosed. The systems may include: a heat exchanger; and a nozzle disposed adjacent the heat exchanger.

In one aspect of the disclosure monolithically integrating the resistive heating region of a doped crystalline material in a base substrate may include implant doping a dopant into the undoped crystalline material of the base substrate to produce the resistive heating region of the doped crystalline material.

In another aspect of the disclosure, an undoped crystalline material of a base substrate may include any homoepitaxial or heteroepitaxial material may include silicon (Si), crystalline silicon (c-Si), silicon carbide (SiC), diamond, polycrystalline diamond, polycrystalline diamond deposited by chemical vapor deposition, single crystal diamond, single crystal diamond deposited by chemical vapor deposition, single crystal high pressure/high temperature diamond, doped Si, polycrystalline doped Si, single crystal doped Si, undoped Si, polycrystalline undoped Si, single crystal undoped Si, single crystal SiC, doped single crystal SiC, undoped single crystal SiC, any of the SiC polymorphs, including SiC polytypes 4h, 6h, 3c, polycrystalline SiC, doped polycrystalline SiC, undoped polycrystalline SiC, any material with a high critical temperature, including silicon mononitride, silicon nitride, and allotropes of carbon, including graphite, or graphene. In another aspect of the disclosure, the dopant may include boron (b), phosphorous (p), nitrogen (n), or aluminum (Al); and a resistive heating region of the doped crystalline material in the base substrate may include a coefficient of thermal expansion (CTE) comparable to the undoped crystalline material.

In one aspect of the disclosure implant doping the dopant into the undoped crystalline or polycrystalline material of a base substrate may include: patterning a profile on a surface of the base substrate; and implant doping the dopant within the patterned profile on the surface of the base substrate. In one aspect of the disclosure, patterning the profile on the surface of the base substrate may include: masking the patterned profile on the surface of the base substrate with a masking material; and removing the masking material after the implant doping. In another aspect of the disclosure, providing the electrical contacts to the resistive heating region may include one or more of: adding metallization in electrical contact with the resistive heating region; forming vias in the base substrate to the resistive heating region; or exposing a portion of the resistive heating region by removing part of the base substrate.

Disclosed methods may include: forming one or more intermediate channels in a side of the base substrate; and enclosing the one or more intermediate channels by bonding another substrate to the side of the base substrate. In another aspect of the disclosure, disclosed methods may include: attaching the nozzle to a thermal compression bonding head having a heat exchanger and a vacuum source; placing the nozzle in thermal communication with the heat exchanger; and placing the at least one vacuum channel in communication with the vacuum source, the at least one vacuum channel being configured to draw a vacuum against the semiconductor die adjacent a surface of the nozzle. In another aspect of the disclosure, providing the base substrate may include forming the base substrate by bonding two or more intermediate substrates together. In yet another aspect of the disclosure, at least one of the intermediate substrates may include a silicon-on-insulator (SOI) wafer substrate, the SOI wafer substrate having a handle layer, a buried oxide layer, and a device layer.

In one aspect of the disclosure, monolithically integrating the resistive heating region of the doped crystalline or polycrystalline material in the base substrate may include implant doping a dopant into undoped crystalline material of the device layer to produce the resistive heating region of the doped crystalline or polycrystalline material. In another aspect of the disclosure, monolithically integrating the resistive heating region of the doped crystalline or polycrystalline material in the base substrate may include: implant doping a dopant into a side of a first of the substrates, and bonding a second of the substrates to the side of the first substrate; implant doping a dopant into sides of first and second of the substrates, and bonding the sides of the first and second substrates together; patterning a profile on a side of a first of the substrate, implant doping a dopant within the patterned profile; and bonding a second of the substrates to the side of the first substrate; and/or patterning profiles on sides of first and second of the substrates, implant doping a dopant within the patterned profiles; and bonding the sides of the first and second substrates together.

Disclosed methods may include: fabricating the nozzle on a per nozzle basis; or fabricating the nozzle at a wafer level for batch production. In another aspect of the disclosure, providing a base substrate having the undoped crystalline material and monolithically integrating the resistive heating region of the doped crystalline or polycrystalline material in the base substrate may include: providing a first substrate of the doped crystalline material and a second substrate of the undoped crystalline or polycrystalline material; bonding the first and second substrates together; and leaving a layer of the doped crystalline or polycrystalline material by cleaving away a portion of the first substrate. Disclosed methods, in one aspect, may include patterning the resistive heating region in the layer by laser machining or chemically etching the resistive heating region in the layer.

One general aspect of the disclosure includes an element, comprising:
a base substrate having an undoped crystalline or polycrystalline material; a resistive heating region of a doped crystalline or polycrystalline material monolithically integrated in the base substrate; one or more engagement features formed into the base substrate; and electrical contacts connected in electrical communication with the resistive heating region.

In some embodiments, the element is a thermal compression bonding nozzle, the one or more engagement features comprises a shoulder in a surface of the base substrate, the shoulder being configured to engage against a portion of a corresponding semiconductor die.

In some embodiments, the element is a temperature sensor, wherein the resistive heating region functions as a resistance temperature detector.

One general aspect of the disclosure includes methods of thermal compression bonding a semiconductor die to a host. In one aspect, methods of thermal compression also include holding the semiconductor die to a nozzle having undoped crystalline or polycrystalline material by drawing a vacuum through at least one vacuum channel in the nozzle; placing contacts of the semiconductor die aligned to solder bumps of the host, and affixing the contacts to the solder bumps by: applying pressure from the nozzle to the semiconductor die against the host, and applying heat from the nozzle to the semiconductor die against the host by resistively heating a monolithically integrated region of doped crystalline or polycrystalline material in the nozzle.

The foregoing summary is not intended to summarize each potential embodiment or every aspect of the present disclosure.

### BRIEF DESCRIPTION OF THE DRAWINGS

Figs. 1A-1D illustrate schematic views of a thermal compression bonding system of the present disclosure having a head that uses a nozzle to thermal compression bond a die to a host substrate.
Fig. 2A illustrates a process to manufacture a first embodiment of a thermal compression bonding nozzle according to the present disclosure.
Fig. 2B illustrates elements of the thermal compression bonding nozzle during manufacture according to the process of Fig. 2A.
Fig. 3A illustrates a process to manufacture a second embodiment of a thermal compression bonding nozzle according to the present disclosure.
Fig. 3B illustrates elements of the thermal compression bonding nozzle during manufacture according to the process of Fig. 3A.
Fig. 4A illustrates a process to manufacture a third embodiment of a thermal compression bonding nozzle according to the present disclosure.
Fig. 4B illustrates elements of the thermal compression bonding nozzle during manufacture according to the process of Fig. 4A.
Fig. 5A illustrates a process to manufacture a fourth embodiment of a thermal compression bonding nozzle according to the present disclosure.
Fig. 5B illustrates elements of the thermal compression bonding nozzle during manufacture according to the process of Fig. 5A.
Fig. 6 illustrates a nozzle of the present disclosure bonded to other components of a thermal compression bonding head.
Figs. 7A-7B illustrate alternative fabrication steps of adding cooling channels in a base substrate of a nozzle and bonding another substrate to the base substrate.
Fig. 8 illustrates schematic examples of shapes for a resistive heating region of the disclosed nozzle.
Fig. 9 illustrates an alternative fabrication step of adding electrical contacts to the resistive heating region integrated into the nozzle.
Fig. 10 illustrates a schematic view of features in a bottom surface of the nozzle according to one example.
FIG. 11 illustrates a schematic view of a nozzle in accordance with the present disclosure.
FIG. 12 illustrates a schematic view of a nozzle in accordance with the present disclosure.
FIG. 13 illustrates a schematic view of a nozzle in accordance with the present disclosure.

### DETAILED DESCRIPTION OF THE DISCLOSURE

Semiconductor processes, for example TCB and other semiconductor die testing and processing, can have limited throughput due to the rates of heating and cooling to appropriate temperatures in processing the dies. In particular, the nozzle is mounted adjacent to a separate heater, which transfers the heat through the nozzle through several thermal interfaces, to reach the die. For example, the interface between the heater element and heater block and the heater block and the surface of the nozzle may act as thermal barriers, which increases the heat/cool time in the TCB process and thus, reduces the productivity (Units Per Hour) of semiconductor die processing. In such configuration, these interfaces may be a limiting factor in the thermal slew rate of the die and thus limit the potential throughput of the TCB, or other semiconductor, process.
Disclosed herein are structures and methods for reducing the effects of one or more of the problems set forth above.

While specific implementations of the disclosure will be discussed with respect to advantages as applied to TCB, as will be discussed further below, other applications of monolithically integrated elements disclosed herein may also be utilized for temperature sensing, solder melting, or testing in processes that benefit from rapid thermal cycling and/or measurement.

One solution to improve the TCB process involves selecting a material of the nozzle with a thermal conductivity that maximizes thermal slew rate. Materials used for the nozzle will be discussed further below, but may include, for example aluminum nitride (AIN) ceramics, crystalline silicon carbide (SiC), and diamond. While some solutions have sought to pattern metal on a nozzle substrate, such solutions are difficult to do from a process standpoint and produce undesirable structural limitations in the resulting nozzle due to the mismatch of CTE between the substrate and heater.

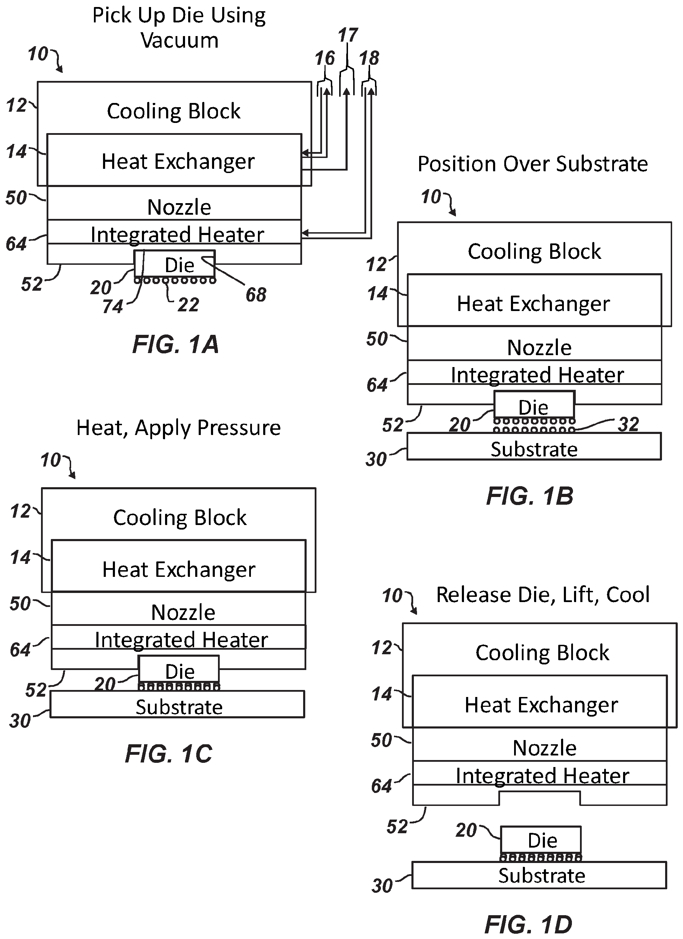

Figs. 1A-1D illustrate schematic views of an example thermal compression bonding system and method in accordance with certain aspects of the present disclosure using a head 10 with a nozzle 50 to thermal compression bond a die 20 to a host substrate 30. The head 10 includes a cooling block 12 having a heat exchanger 14. The nozzle 50 is attached to the cooling block 12 and includes a resistive heating region 64 according to the present disclosure monolithically integrated into the nozzle's material.

The nozzle 50 also includes alignment or engagement features 68 for engaging and holding the die 20 to be thermal compression bonded. In general, the engagement features 68 include one or more vacuum holes (not shown) to produce a vacuum to hold the die 20 to the nozzle 50, however, the engagement features 68 need not necessarily be vacuum based and may include (either additionally or alternatively) other retention mechanisms such as pin arrays, pressure application, recessed structural features, or interference fits. Alignment features (discussed herein with reference generally to engagement features 68) may include other alignment or mechanical engagement features such as recesses or matching keyed structural features for a particular die 20 (or other component or material being processed or tested). For example, a "negative" engagement feature 68 feature may be formed into nozzle 50 that fits the "positive" shape of the die 20 or is sufficiently close in size to the die 20 to allow for vacuum or interference engagement of the die 20. Thus, a die interface surface 74 may be formed within such engagement features 68 which provides a surface point of contact, which is one example may be parallel with a bottom surface 52 of the nozzle. As shown in the example of FIG. 1A, the die interface surface 74 is recessed from the bottom surface 52, however, in other examples in which negative engagement features 68 are not required or needed, die interface surface 74 may also be even with or proud of the bottom surface 52. Additionally, the engagement features 68 can include shoulders, pockets, trenches, and other features in the bottom surface 52 of the nozzle 50, which will also be discussed further below.

Typically, the head 10 is supported by additional components of the system, such as an active tip-tilt (not shown) allowing the tilt alignment of the head 10 to be actively controlled. Bearings, force sensors, and linear actuator (not shown) can also be used to support and move the head 10 vertically or in another axis. Cooling lines 16 are connected to the heat exchanger 14 and conduct fluid coolant (*e.g.,* air, helium, carbon dioxide, water etc.), which can be in a suitable form (*e.g.,* gas, liquid, compressed, etc.) to cool the nozzle 50. Alternatively, as will be discussed below, cooling channels may be formed directly in the nozzle, in which case the cooling block 12 may be omitted.

Vacuum lines 17 connected to the head 10 communicate through one or more internal channels, ports, and the like (not shown) through the nozzle 50 to pull a vacuum to hold the die 20 to the bottom surface 52 of the nozzle 50. Power lines 18 are connected to the integrated resistive heating region 64 of the nozzle 50 to provide power to resistively heat the resistive heating region 64.

The die 20 can be any conventional semiconductor device having contacts 22 (*e.g.,* copper pillar bumps) for electrical and mechanical connection to solder bumps 32 on a host substrate 30. The host substrate 30 can be supported on a hot pedestal (not shown) of a bonding stage (not shown) that can move the host substrate 30 under the head 10.

In the thermal compression bonding process, the die 20 is aligned (Fig. 1B), placed, force applied, and thermally cycled (Fig. 1C) to reflow the solder bumps 32 so the die's contacts 22 make electrical and/or mechanical contact with the solder bumps 32 on the host substrate 30. As shown in Fig. 1A, the head 10 picks up the die 20 using the vacuum and engagement features 68 of the nozzle 50.

As shown in Fig. 1B, the head 10 is positioned over the host substrate 30 so that the copper pillar bumps 22 are matched to the corresponding solder bumps 32. As shown in Fig. 1C, the head 10 applies pressure (by moving towards the substrate 30) and heat (transferred from the resistive heating region 64 portion of nozzle 50 and the bottom surface 52 to the die 20) to thermal compression bond the copper pillar bumps 22 to the solder bumps 32 on the host substrate 30. Heating is generated by resistive heating of the resistive heating region 64 monolithically integrated into the nozzle 50.

To do this, the resistive heating region 64 is cycled up to an elevated temperature, typically high enough to melt the solder bumps 32. The nozzle 50 then provides thermal conduction to the die 20 via a flat interface surface, which acts as a thermal spreader to ensure uniformity of temperature (and thus bonding temperature/time) from the heating region 64 to the die 20. The degree and time at the elevated temperature depends on the type of materials used in the solder bumps 32 as well as other factors and the process being used. For example, TCB may require a higher temperature than a heating application which is primarily testing the die 20. In general, the heat from the resistive heating region 64 passes from the nozzle 50 to the die 20 so the solder bumps 32 can melt and flow to solder to the die's contacts 22. The cycling up to the elevated temperature is preferably done rapidly so the processing of each die 20 can be done efficiently. Once the elevated temperature is reached for an appropriate amount of time, activation of the integrated resistive heating region 64 is stopped and cooling can begin.

As shown in Fig. 1D, the nozzle 50 is then released and lifted from the die 20, which is left affixed to the substrate 30. The head 10 is then cooled so processing of the next die 20 can be performed. The cooling is also preferably done quickly to reduce the idle time between processing, which enables more die 20 processing over time.

The head 10 of Figs. 1A-1D includes the heat exchanger 14 for cooling the nozzle 50 and includes one or more resistive heating region(s) 64 integrated into the nozzle 50. The nozzle 50 includes engagement features 68, such as precision alignment features and vacuum channels, to handle the die 20 during the pickup, positioning, and attachment processes. The nozzle 50 thermally conducts the heat to the die 20 via an interface surface (e.g., bottom surface 52), which spreads the temperature in a uniform distribution or pattern from the resistive heating region 64 and nozzle 50 to the die 20.

Material transitions, such as those between a nozzle and a separate heater present in the prior art may result in an increased thermal barrier. Such thermal barriers may result, for example from the interface between disparate materials. Further, for multi-material stacks, layers of different materials may need to be robust enough to stand free, which requires a minimum layer thickness. This can increase the distance the heat needs to cross (from the heater to the nozzle / die) and also increases the thermal mass of the stack, which in turn increases the thermal cycling time between heat-up and cool-down (or vice versa), can reduce the efficiency of the heat transfer, and may increase failure rates. Thermal barriers and long heat distances reduce the productivity (Units Per Hour) and increases the heat/cool processing time, for example in the TCB process or other sensing applications.

Moreover, as discussed previously embedding metal traces into a nozzle to produce resistive heat produces undesirable structural limitations in the nozzle. For example, metal heater traces embedded in a nozzle experience differential thermal expansion and would have a different mechanical strength than the nozzle material. This may introduce discontinuities or stress in the nozzle structure, making the nozzle structure more likely to fail with its repeated use and/or require thicker nozzle materials.

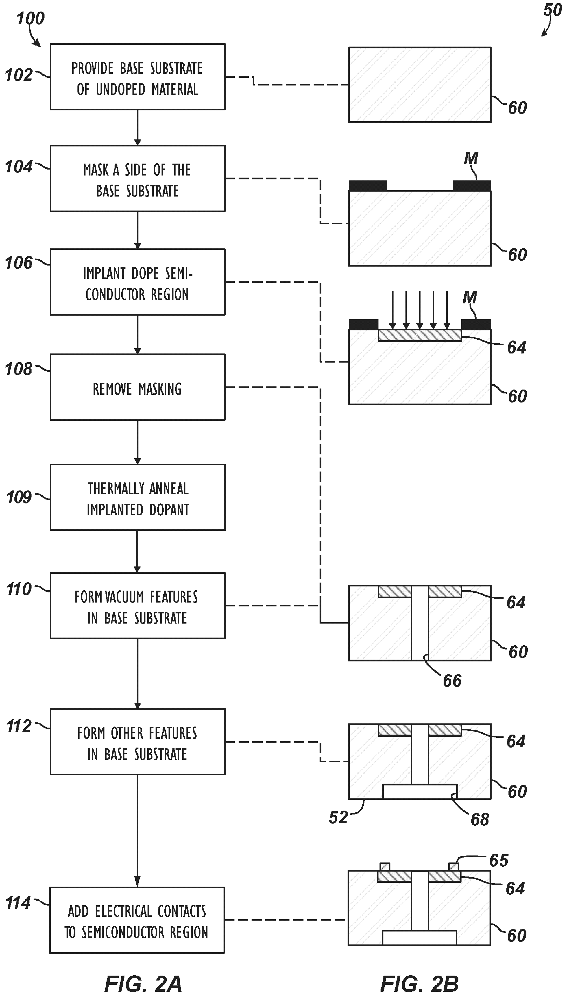

The disclosed nozzles 50 include various embodiments such as an integrated resistive heating region 64 of the nozzle 50 separate from, or excluding, embedded or separate metal heater traces. As described further, with reference to Figs. 2A-5B , disclosed nozzles 50 include a crystalline or polycrystalline substrate 60 having one or more integrated resistive heating region(s) 64 formed therein. As discussed below, the crystalline substrate 60 of the nozzle 50 can include crystalline silicon (c-Si), silicon carbide (SiC), single crystal diamond, polycrystalline diamond, or the like.

One or more doped semiconductor regions are added to the crystalline substrate 60 as one or more integrated resistive heating region(s) 64, either on the surface of the crystalline substrate 60 or within the substrate 60 itself. By integrating the resistive heating region(s) 64 in the nozzle 50, the head 10 has fewer thermal barriers and the heat/cool time can be reduced.

The added doped semiconductor resistive heating region(s) 64 will have a coefficient of thermal expansion (CTE) comparable to the substrate 60. For example, the difference between the CTE of the doped semiconductor resistive heating region(s) 64 and CTE of the substrate 60 is substantially less than the difference between the CTE of comparable metal heater traces and respective nozzles of alternative configurations having similar heat output. In this way, discontinuities generated by thermal expansion are reduced. For example, the doped semiconductor region 64 may be doped (with example dopants described below) to a concentration from about 1 x 10¹⁸ to about 1 x 10¹⁹ atoms/cm³ with little to no distinguishable difference in CTE from substrate 60. With the substrate 60 material for the nozzle 50 having CTE that is matched to the CTE of the resistive heating region(s) 64 the entire structure expands and contracts equally, thus reducing stress and damage when exposed to the large temperature excursions required during use. In one example, doping silicon with boron atoms to a nominal level of 10²⁰ boron atoms per cm³ only increased the CTE of Si over the range 293-550 K by 1.1 × 10⁻⁸/*K*, which is a sufficiently minimal impact on CTE such that the CTEs would be considered matched. See for example, the Journal of Vacuum Science & Technology A: Vacuum, Surfaces, and Films (Volume:9 , Issue: 4, p. 2231)(1991), which is hereby incorporated by reference in its entirety. As discussed below, the doped semiconductor resistive heating region(s) 64 can provide greater flexibility in its location within the nozzle, which enables placing it closer (or further) to the bottom surface 52, which can also increase the thermal slew rate.

Although the nozzle 50 can be used for thermocompression bonding semiconductor dies to a host substrate, the nozzles 50 disclosed herein having resistive heating region(s) 64 monolithically integrated therein can be used for other fabrication processes, including direct bonding, surface activated bonding, plasma activated bonding, anodic bonding, eutectic bonding, glass frit bonding, adhesive bonding, reactive bonding, and transient liquid phase diffusion bonding.

The nozzle 50 and integrated resistive heating region(s) 64 of the present disclosure can be fabricated in a number of ways as disclosed below. In general, doping semiconductor region(s) 64 in the crystalline substrate 60 can achieve a suitable resistance. Lithographic processing can be used to contour the doped region(s) 64 and to produce mechanical features in the nozzle 50. Metallization processes appropriate for the nozzle materials can be used to provide electrical contacts 65 and the like to the doped region(s) 64. Vias, channels, trenches, and other features can be formed in the nozzle 50. Fabrication can be performed on a per nozzle basis or can be performed at a wafer level for batch production.

Fig. 2A illustrates an example process 100 to manufacture a nozzle 50 according to one embodiment. Nozzle 50 of Fig. 2A may be used for example, as described in example embodiments with respect to Fig. 1A-1D.

However, the use of the nozzle 50 is not limited for TCB. In other embodiments, the nozzle 50 may be used for other applications in which rapid thermal cycling may be advantageous, such as semiconductor testing, materials processing, or materials handling. For example, disclosed examples also have application with other high throughput processes that include high or low temperature cycling and/or measurement, treating, or testing that would benefit from faster thermal cycling.

Fig. 2B schematically shows elements of the nozzle 50 during the process 100. The process 100 may start with a base substrate 60 having an undoped material and having first and second sides (Block 102). In general, the base substrate 60 can comprise a substrate of undoped, crystalline or polycrystalline material. The undoped material of the base substrate may comprise any homoepitaxial or heteroepitaxial material, or monocrystalline or polycrystalline material, comprising silicon (Si), crystalline silicon (c-Si), aluminum nitride, silicon carbide (SiC), reaction-bonded silicon carbide (RB-SiC), diamond, polycrystalline diamond, polycrystalline diamond chemical deposited by vapor deposition, single crystal diamond, single crystal diamond deposited by chemical vapor deposition, single crystal high pressure/high temperature diamond, doped Si, polycrystalline doped Si, single crystal doped Si, undoped Si, polycrystalline undoped Si, single crystal undoped Si, single crystal SiC, doped single crystal SiC, undoped single crystal SiC, any of the SiC polymorphs, including SiC polytypes 4H, 6H, 3C, polycrystalline SiC, doped polycrystalline SiC, undoped polycrystalline SiC, any material with a high critical temperature, including silicon mononitride, and allotropes of carbon, including graphite, or graphene, or the like, either alone or in combination.

Alternatively, the base substrate 60 can comprise a pre-manufactured silicon-on-insulator (SOI) wafer substrate having a handle layer of undoped material, a buried oxide layer, and a device layer. Further still, the base substrate 60 can comprise a combination of two or more substrates bonded together. In some embodiments, an electrostatic discharge layer is disposed on the insulator of the SOI wafer substrate.

A profile can be patterned on the first side of the base substrate 60 (Block 104). For example, masking M, which can be any suitable masking agent, can be applied to the top side of the base substrate 60 to form a patterned profile, which can have a suitable shape. One or more resistive heating regions 64 are then integrated into the base substrate 60 by doping a dopant in the top side of the base substrate 60 within the patterned profile of the masking (Block 106). For example, the dopant can be doped in the base substrate 60 by ion implantation, by which ions of the dopant are accelerated into substrate 60, at low temperatures and then remain in substrate 60.

The dopant used can depend on the substrate's material. Example dopants can include boron (B), phosphorous (P), nitrogen (N), or aluminum (Al). The ion implantation is configured to produce sufficient dopant concentration and thickness of the implanted region(s) 64 so an appropriate level of electrical conductivity can be achieved in the layer of the resistive heating region(s) 64 for the desired heating effect for the given area doped.

While ion implantation manufactures an integrated heating nozzle, the same process can also be used to form temperature, pressure, stress, or strain sensors - any that measure change in resistance as an indicator of change in the parameter of interest.

In configuring the implant doping process, considerations are made to avoid damaging defects in the crystalline structure of the substrate material. In the implant doping process, the implanted dopant is activated using high-temperature annealing to ensure the consistent density of the dopant and so electrical contacts 65 on the top surface can conduct with the resistive heating region(s) 64.

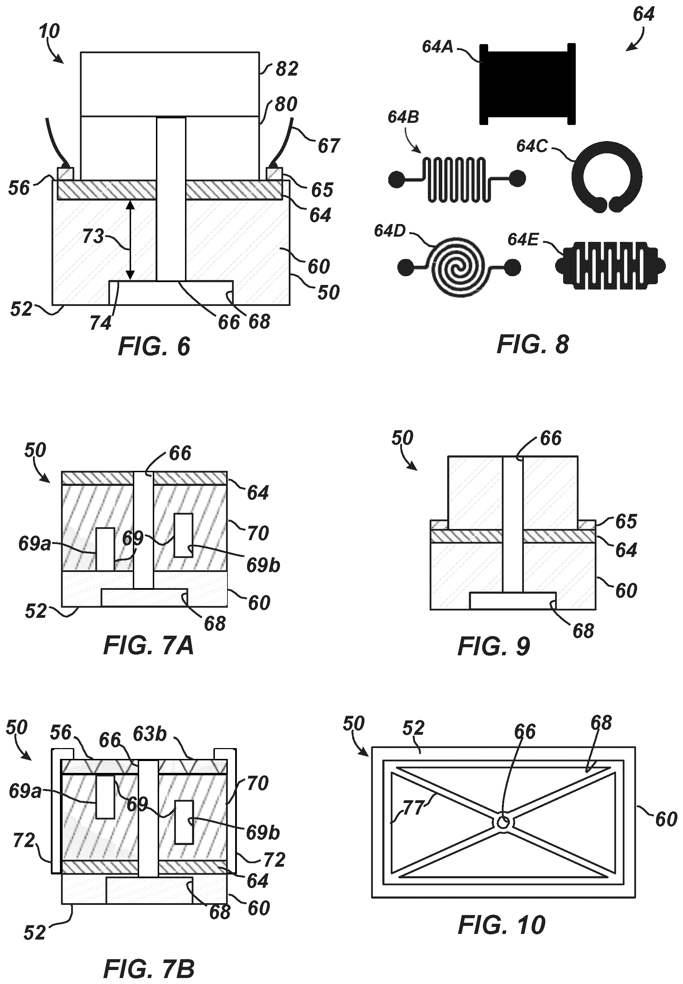

The masking M, and thus, resistive heating region(s) 64 can have any desired shape, length, and other dimensions to produce the heat and heating profile to be conducted from the nozzle to the semiconductor die (not shown. Some typical shapes for the resistive heating region(s) 64 can include a spiral shape, a ring shape, a serpentine shape, a coiled shape, a grid shape, a layer or plate shape, and the like, as discussed below with reference to Fig. 8. As expected, the shape is preferably that which can provide uniform heating so the copper pillars on the die can be thermally compression bonded to solder bumps as disclosed herein. Accordingly, the shape of the resistive heating region can be tailored to the expected size of the die 20 or other engagement features 68.

Once doping is done, the masking M is then removed (Block 108) by a process appropriate to the masking material. In case the masking agent comprises photoresist, the photoresist may be removed by, for example a mechanical machining or a chemical removal process, such as etching. After removing the masking M, the surface of the base substrate 60 may be cleaned, for example with one or more acids. The implanted dopant may be thermally annealed (Block 109).

For use in TCB, or other applications in which the die will be held by the nozzle 50, one or more engagement features 66, 68 may optionally be formed in the base substrate 60. In particular, the engagement features shown in FIG. 2B include one or more vacuum channels 66 or hole communicating through the base substrate 60 (Block 110). The one or more vacuum channels 66 allow for a vacuum to be pulled through the nozzle 50 so a die can be held against a bottom surface 52 of the nozzle 50. In addition to the vacuum channel 66, other engagement features 68, such as trenches or channels, can be formed in the bottom surface 52 of the substrate 60 to pneumatically communicate with the vacuum channel(s) 66 so the vacuum can be applied to more of a die's surface when held adjacent to the bottom surface 52 of the nozzle 50 (Block 112). The engagement features 68 can also include a shoulder, a pocket, an edge, a contour, or the like configured to engage a portion of the semiconductor die thereagainst and can be adapted or tailored to match with features of a particular die. Forming the engagement features 66, 68 can use laser machining processes or lithographically defined chemical etching processes.

Electrical contacts 65 are applied to the resistive heating region(s) 64 on the top surface 56 of the base substrate 60 (Block 114) or otherwise in electrical communication with the resistive heating region, for example by depositing a layer of titanium, platinum, and gold on the Si-substrate, through electron-beam physical vapor deposition. In an example in which the resistive heating region 64 is formed to an edge or side surface of the nozzle 50, the electrical contracts 65 may be made on such side surfaces (see Fig. 7b, discussed below).

As shown in Fig. 6, the nozzle 50 once fabricated can be incorporated into other components of a thermal compression bonding head 10. For example, the top surface of the nozzle 50 can be bonded to components having a cooling element 80 (*e.g.,* heat exchanger) and a vacuum source 82 (*e.g.,* ports, channels, and the like connected to a remote vacuum pump by vacuum lines). The nozzle 50 is placed in thermal communication with the cooling element 80, and one or more vacuum channels 66 are placed in pneumatic communication with the vacuum source 82. As also shown in Fig. 6, electrical connections to the electrical contacts 65 can use wire bonds 67 or any other conventional technique. The resistive heating region 64 may be an offset distance 73 from the engagement feature 68, i.e., at the location of die contact (the die interface surface 74). Distance 73 may be from about 0 to about 10 mm. However, a greater distance 73 will require more material and thus longer heating and cooling time, while distances 73 above 0 microns may be advantageous to spread the heat evenly and to provide protection for resistive heating region 64. Thus, a more preferable distance 73 is greater than 0 microns to about 5 mm. In another example, the distance 73 is from about 100 microns to about 5 mm.

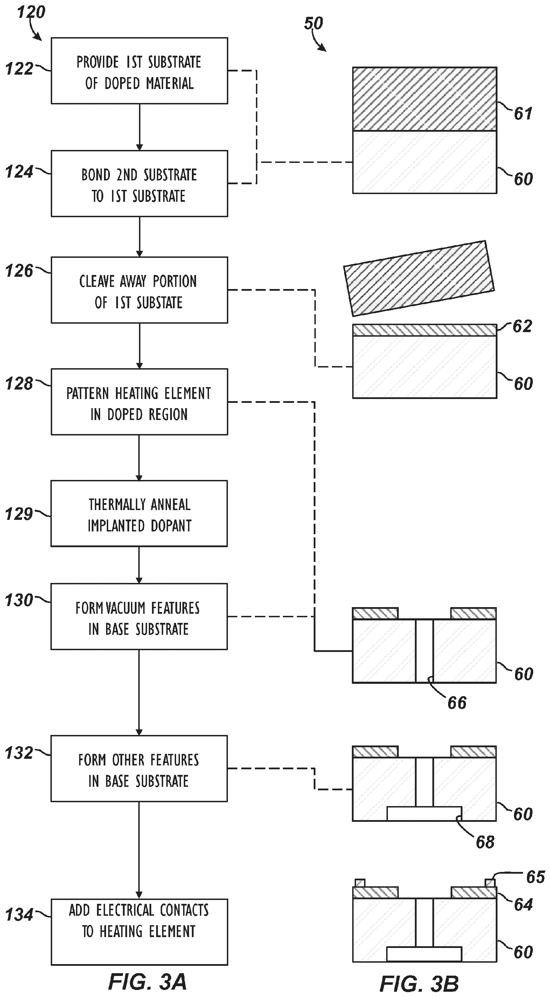

Fig. 3A illustrates a process 120 to manufacture a nozzle 50 according to a second embodiment for thermal compression bonding (TCB) of a semiconductor die to a host. Fig. 3B schematically shows elements of the nozzle 50 during manufacture, for example, according to process 120. Nozzle 50 of FIG. 3B may have similar elements and features discussed with nozzle 50 of FIGS 1 and 2B.

A substrate is formed for the nozzle 50 using a base substrate 60 of undoped material and a second substrate 61 of doped material. The substrates 60, 61 are bonded together (Blocks 122-124). For example, wafer bonding and annealing processes, such as direct bonding or other, can be used depending on the substrate materials, surfaces, and other factors. For example wafer bonding may include polishing two wafers and contacting the wafers together such that the two wafers adhere to each through the van der Waals force. Annealing provides for the diffusion of atoms from the first base substrate 60 to the second substrate 61 or vice versa until an equilibrium state is reached, thereby creating a bond.

A resistive layer 62 of the doped material is then left on the top of the base substrate 60 by cleaving away a portion of the upper substrate 61 (Block 126). For example, a defect layer (crystallographic layer with interruptions of positions of atoms at repeating fixed distances) is produced intermediately in the subject substrate 61 using ion implantation (see above) so a portion of the substrate 61 can be split way. Annealing and chemical mechanical polishing (CMP) can then be performed on the remaining resistive layer 62. It should be noted, that for purposes of explanation, the term "resistive" is being use in this context for resistive layer 62 (even though it is formed out of the relatively higher conductive doped second substrate 61), because the layer 62 will ultimately form the "resistive" heating region 64, which produces heat through resistive losses.

One or more resistive heating region(s) 64 can then be patterned in the resistive layer 62 (Block 128). For example, the resistive heating region(s) 64 can have an appropriate shape, similar to that described with reference to Fig. 2B and Fig. 8, and can be formed by laser machining, chemical etching, or the like in the resistive layer 62. An additional substrate (not shown) can be bonded to the resistive layer 62 to provide the base substrate for the nozzle 50. For example, in case a mechanical substrate is needed to be of a material not suited for doping, a substrate with integrated heating can be attached to the additional substrate. The implanted dopant may be thermally annealed (Block 129).

One or more engagement features 66, 68 may then be formed in the base substrate 60. In particular, the engagement features include one or more vacuum channels 66 communicating through the base substrate 60 (Block 130). Trenches, pockets, or other features 68 noted herein can also be formed in the bottom of the base substrate 60 (Block 132). Electrical contacts 65 may then be provided to the resistive heating region(s) 64 (Block 134), as discussed above.

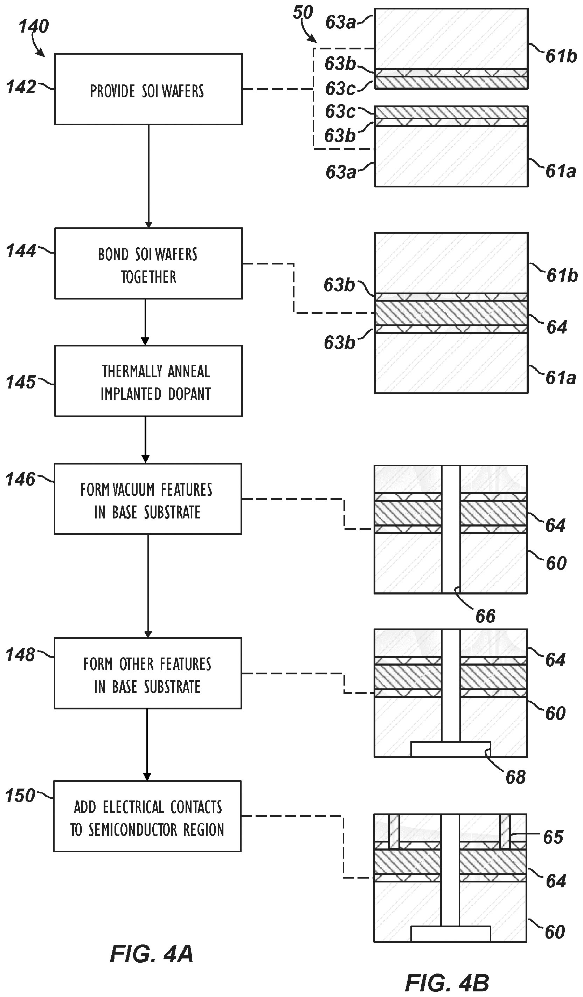

Fig. 4A illustrates a process 140 to manufacture a nozzle 50 according to a third embodiment for thermal compression bonding (TCB) of a semiconductor die to a host. Fig. 4B schematically shows examples of the nozzle 50 during manufacture, for example, in accordance with process 140. Nozzle 50 of FIG. 4B may have similar elements and features discussed with nozzle 50 of FIGS 1,2B, and 3B.

Here, a base substrate 60 is formed for the nozzle 50 by using two or more substrates, e.g., 61a and 61b (Block 142). At least one of these two substrates 61a, 61b can be a pre-manufactured silicon on insulator (SOI) wafer substrate. The SOI wafer substrate 61a, 61b may include a handle layer 63a of undoped material, a buried oxide layer 63b, and a device layer 63c. At least a portion of at least one of the device layers 63c can be implanted with a dopant to form a resistive layer or one or more resistive heating regions 64. Further, while buried oxide layers 63b are shown in both 61a and 61b, it may be advantageous to omit the buried oxide layers 63b of substrate 61b to reduce the thermal barrier between the resulting resistive heating region 64 and the bottom surface of the nozzle.

As will be appreciated, even though the device layers 63c are depicted as entirely doped layers in Fig. 4B, masking and implant doping can be used to produce doped material for one or more resistive heating regions 64 in either one or both of the device layers 63c as described above.

The device layers 63c are bonded together to form the resistive heating region(s) 64 between the buried oxide layers 63b of the SOI wafer substrates 61a, 61b (Block 144). The implanted dopant may be thermally annealed (Block 145).

Similar to the embodiments described above, one or more engagement features 66, 68 may then formed in the base substrate 60. In particular, the engagement features include one or more vacuum channels 66 communicating through the base substrate 60 (Block 146). Trenches, pockets, or other features 68 can also be formed in the bottom of the base substrate 60 (Block 148).

Wafer bonding and annealing processes available in the art can be used to bond the wafer substrates 61a, 61b together. Electrical contacts (are then made to the resistive heating region(s) 64 (Block 150). For example, conductive vias 65 can be formed in the top side of the base structure through the handle layer 63a of the upper SOI wafer substrate 61b to the resistive heating region(s) 64 (Block 150). Alternatively, parts of the upper wafer substrate 61b, such as at the edges, can be removed to expose portions of the resistive heating region (64) so the electrical contacts 65 can be added. Fig. 9 illustrates an alternative fabrication step also applicable to the embodiment of FIG. 4B, which includes adding electrical contacts 65 to the resistive heating region 64, where edges of the substrate (e.g. 61b) are exposed to contact the resistive heating region(s) 64 by electrical contacts 65.

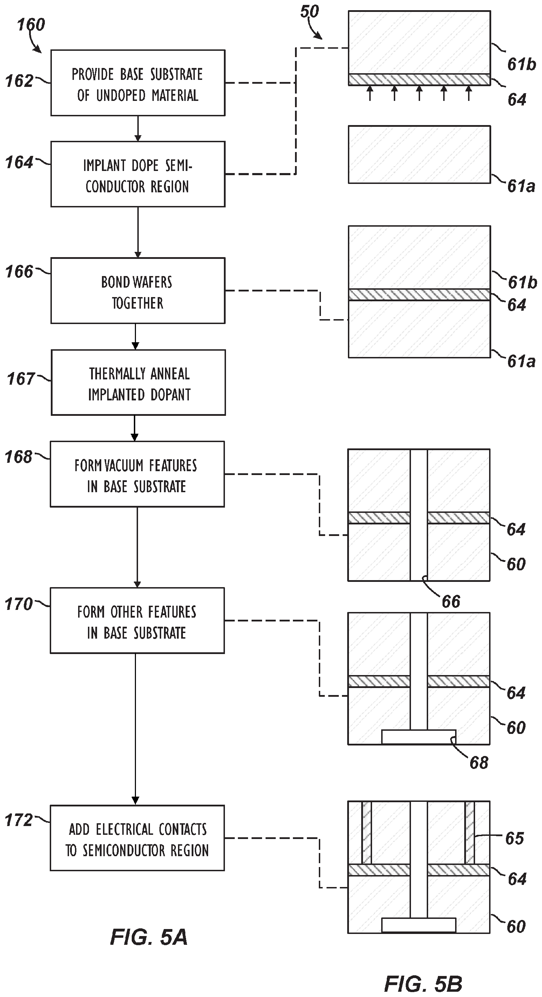

In the produced nozzle 50 of FIG. 4B, the buried oxide layers 63b can act as electrical and thermal insulation for the resistive heating region(s) 64. While Figs. 4A and 4B illustrate the process to manufacture a nozzle using a buried oxide layers 63b, Figs. 5A and 5B illustrate the process to manufacture a nozzle without using a buried oxide layers 63b. Although it should be noted that features of FIGS. 4A-5B can be mixed, for example bonding a substrate 61b with a buried oxide to a substrate 61a without a buried oxide to produce an insulator on only one side of the resistive heating region 64 (e.g., on the opposite side of the resistive heating region 64 from engagement features 68.

Fig. 5A illustrates a process 160 to manufacture a nozzle 50 according to a fourth embodiment for thermal compression bonding (TCB) of a semiconductor die to a host. Fig. 5B schematically shows examples of the nozzle 50 during the manufacture, for example, by process 160. Nozzle 50 of FIG. 5B may have similar elements and features discussed with nozzle 50 of FIGS 1, 2B, 3B, and 4B.

A base substrate 60 is formed for the nozzle 50 using first and second substrates 61a, 61b of undoped material. A resistive layer or one or more resistive heating regions 64 is formed in one of the substrates 61b by implant doping the substrate 61b (Blocks 162-164). As will be appreciated, even though the resistive heating region 64 is depicted as an entire resistive layer in Fig. 5B, masking and implant doping can be used to produce resistive heating region(s) 64 having any desired shape, length, and other dimensions.

The two substrates 61a, 61b are bonded together so that the resistive heating region 64 is connected between the undoped material 61a, 61b (Block 166). The implanted dopant may be thermally annealed (Block 167).

Again, one or more engagement features 66, 68 are then formed in the base substrate 60. In particular, the engagement features include one or more vacuum channels 66 communicating through the base substrate 60 (Block 168). Trenches, pockets, or other features 68 can also be formed in the bottom of the base substrate 60 (Block 170).

Electrical contacts 65 are then provided to the resistive heating region 64 (Block 172). For example, conductive vias can be formed in the top of the structure to the resistive heating region 64. Alternatively, parts of the upper wafer substrate 61b, such as at the edges, can be removed to expose portions of the resistive heating region (64) to the electrical contacts 65 can be added. Fig. 9 illustrates an alternative fabrication step of adding electrical contacts 65 to the resistive heating region 64, where edges of the substrate are exposed to contact the resistive heating region(s) 64 by electrical contacts 65, which is also applicable to the embodiment of Fig. 5B.

Figs. 7A-7B illustrate alternative fabrication steps of adding channels 69 in a base substrate 60 and bonding additional substrate 70 to the base substrate 60.

The nozzle 50 of Fig. 7A is similar to the nozzle 10 of FIG. 6. However as shown, the nozzle 50 includes optional additional substrate 70 and/or channels 69, which are features that can be incorporated into any of the example nozzles 50 disclosed herein. The additional substrate 70 can be used for heat spreading, contact protection, or adding additional features. The additional substrate 70 may be made of the same or similar materials as base substrate 60. In other embodiments, additional substrate 70 may be made of different materials depending on the desired thermal conductivity or other thermal properties.

Channels 69 may control the distribution of heat transfer through the base substrate 60 and/or additional substrate 70. In one example, the channels 69 can be cooling channels to provide cooling of the nozzle 50 before or after heating of the resistive heating region 64. For example, fluid coolant (e.g., air, helium, carbon dioxide, water etc.), which can be in a suitable form (e.g., gas, liquid, compressed, etc.) or another coolant can be passed through the cooling channels 69 and fluidically connected to cooling lines 16 (Fig. 1A). Channels 69 may be at any distance from substrate 60. As shown, channel 69a is directly in contact with substrate 60, while channel 69b is offset from substrate 60. Channels 69a and 69b may be at the same offset from substrate 60 or different than each other.

The channels 69 may be formed in a surface of the additional substrate 60, e.g., though one or more chemical, laser, or mechanical means, such as wet or dry chemical etching, dicing, or drilling or the channels 69 may be formed during formation of the additional substrate 70. The additional substrate 70 is bonded to the surface of the base substrate 60 to enclose the channels 69. While the embodiment of Fig. 7A shows an additional substrate 70 distinct from substrate 60, alternatively, the features can be formed in a single unitary substrate 60.

As shown in Fig. 7A, the additional substrate 70 and channels 69 can be included in the bottom part of the nozzle 50 between the resistive heating region 64 and the bottom surface 52, where the nozzle 50 engages a die (not shown). As shown in Fig. 7B, the additional substrate 70 and channels 69 can, alternatively, be included in the top part of the nozzle 50, i.e., such that the resistive heating region 64 is between the bottom surface 52 and the channels 69.

The nozzle 50 shown in Fig. 7B optionally includes a thermal isolation layer, which is shown as oxide layer 63b with channels 69 between the thermal isolation layer (oxide layer 63b) and the resistive heating region 64. Oxide layer 63b can be a part of a silicon on insulator substrate, a layer of silicon dioxide, or can be formed by creating an amorphous region in additional substrate 70, for example by etching, oxidization, or a spun on coating. The resistive heating region 64 includes areas that reach the edge of the nozzle 50 and are electrically accessible via edge or wrap around metallization 72, which may be electrically connected to a top surface 56 of the nozzle for further electrical connections.

Additional substrate 70 and/or channels 69 may also be included in other embodiments disclosed herein. The additional substrate 70 may either be preformed or may be, for example, formed in place.

Fig. 8 illustrates schematic examples of shapes for the resistive heating region 64 of the disclosed nozzle, which are viewed in a plane parallel to a mask surface M (Fig. 2B) or the die (or in a plane perpendicular to the cross-section plane of FIG.6). In general, the resistive heating region 64 can be a resistive heating region having any shape suitable configured to distribute heat to the desired die, for example a layer or plate shape 64A, a serpentine shape 64B, a ring shape 64C, a spiral shape 64D, or a segmented shape 64E between electrical contact points. The electrical contacts may be point contacts (e.g., those of shapes 64B, 64C, 64D, 64E) or they may be line contacts (e.g., as shown in shape 64A) to provide more current distribution. As will be appreciated, any number of shapes and dimensions can be used depending on the implementation. Moreover, one or more resistive heating regions 64, including one or more shapes, can be used together on a nozzle, depending on the surface area to be heated and the heat transfer required.

Fig. 9 illustrates an alternative fabrication step of adding electrical contacts 65 to the resistive heating region 64 integrated into the nozzle 50. Instead of using vias formed in the substrate 60 as previously shown, edges of the substrate 60 can be shaped by laser machining or chemical etching to expose edge points of contact for the resistive heating region(s) 64 where electrical contacts 65 can be added.

As noted above, the nozzles 50 disclosed herein may include one or more vacuum channels 66 so that vacuum can be drawn through the nozzle 50 to hold a semiconductor die 20 to the bottom surface 52 of the nozzle 50. To help distribute the vacuum across the surface area of the semiconductor die 20, various trenches, channels, and the like can be formed on the bottom surface 52 of the nozzle 50. Additionally, reliefs, shoulders, pockets, and the like can be formed on the nozzle's bottom surface 52 to control the seal against the die 20. These and other features can be formed in the bottom surface 52 of the nozzle 50 so that nozzle 50 can make a sufficient vacuum seal to hold the die 20 firmly against the nozzle 50 and keep the die 20 aligned during the thermal compression bonding or other process operations.

As one example, Fig. 10 illustrates a schematic view of features in a bottom surface 52 of a nozzle 50. The substrate 60 is shown with a vacuum channel 66 that connects with an engagement feature 68 in the bottom surface 52 of the nozzle 50. In this example, the vacuum channel 66 is centrally located, and the engagement features 68 formed in the surface of the base substrate 60 are connected with the vacuum channel 66 and are formed about the periphery of the nozzle 50, which are shown as lateral channels 77. This can bring the vacuum pulled by the vacuum channel 66 to a wider surface area of a die to be held against the bottom surface 52 of the nozzle 50. As will be appreciated, various other configurations with one or more trenches and channels could be used.

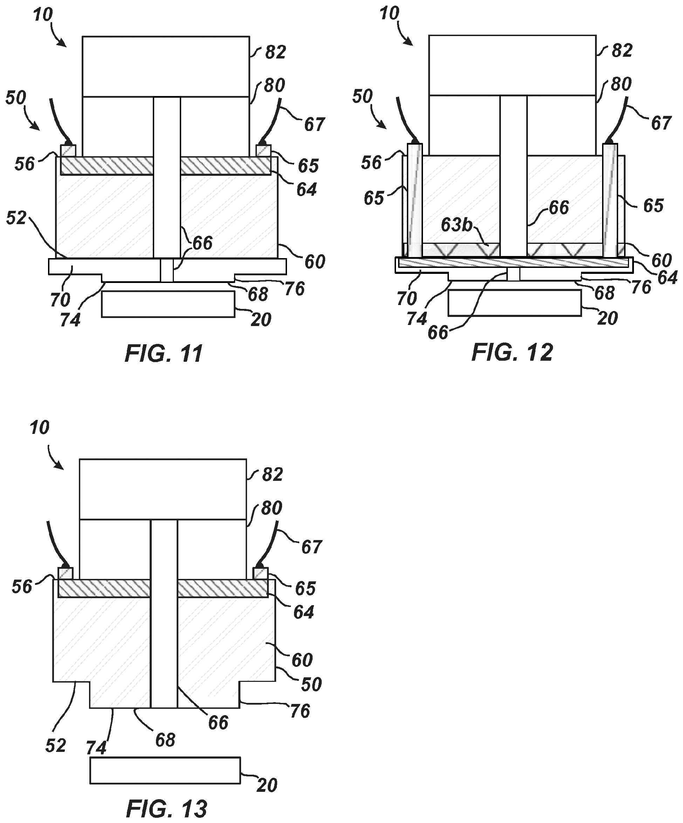

FIG. 11 shows alternative features that may be integrated into the above disclosed nozzles 50 and substrates 60. In FIG. 11, the engagement feature(s) 68 that form the die interface surface 74 are formed in an additional substrate 70 or "plate" that is formed for the purpose of a unique interface to a semiconductor die 20. The additional substrate 70 may be the same or different material as base substrate 60 and can be made of one or more of the materials discussed above with respect to base substrate 60.

The additional substrate 70 may also include one or more vacuum channels 66 for communicating the vacuum to the semiconductor die. The additional substrate 70 may be held in place against the substrate 60 by the vacuum communicated through the vacuum channels 66 within substrate 60. The additional substrate may be set into one or more engagement features of the substrate 60 (similar to the recesses of the prior disclosed embodiments) or the additional substrate 70 may abut or stand proud of the bottom surface 52 of substrate 60 (as shown in FIG. 11). As shown in FIG. 11, the engagement features 68 includes a die interface surface 74 on a raised stand-off portion 76 that is sized to correspond to the semiconductor die 20. The other engagement features, for example, additional vacuum channels discussed with reference to FIG. 10 may also be applied to the additional substate 70. The features of FIG. 11 provide additional interchangeability of the nozzle 50 and head 10 using a plurality of different interchangeable additional substrates 70 sized for different semiconductor dies.

FIG. 12 shows similar features as those in FIG. 11 that may be integrated into the above disclosed nozzles 50 and substrates 60. In FIG. 12, the resistive heating region 64 is within the additional substrate 70, which abut electrical contacts 65 and which may be formed as conductive vias. A thermal isolation layer (shown as an oxide layer 63b) may be included in the substrate 60. Like FIG. 11, the additional substrate 70 includes an engagement feature 68 having a die interface surface 74 on a raised stand-off portion 76 that is sized to correspond to the semiconductor die 20. The additional substrate may be removably held in place to the substrate 60 with vacuum communicated via one or more vacuum channels 66. Additional cooling channels 69 (disclosed above) may also be included.

FIG. 13 shows similar features as those in FIG. 6 that may be integrated into the above disclosed nozzles 50 and substrates 60. Compared to the nozzle 50 of FIG. 6, in FIG. 13, the engagement features 68 include a die interface surface 74 on a raised stand-off portion 76 (raised with respect to bottom surface 52) that is sized to correspond to the semiconductor die 20.

As discussed above, while specific implementations of the disclosure have been discussed with respect TCB, other applications of monolithically integrated elements disclosed herein may also be utilized for temperature sensing in applications that benefit from rapid thermal cycling and/or measurement including applications that need to be heated and held to temperatures precisely and consistently. For example, the resistive heating region 64 may also function as a resistance temperature detector (RTD). Based on the construction of the resistive heating region 64, discussed above, resistive heating region 64 may also be referred to herein as a doped resistive element, and have a resistance that varies based on the temperature. For example, the resistance can vary, e.g., increase, as the temperature increases. In one example, the resistance of the doped resistive element may vary proportionally or inversely proportionally to the temperature of the doped resistive element.

Accordingly, the resistive heating region 64 (or doped resistive element) may be used as both a heater and temperature detector. In one example, temperature readings are measured by measuring the resistance through the resistive region 64 periodically in-between, passing current through the resistive heating region 64. In this way, the doped resistive element may function as a monolithically integrated heater and/or sensor, having similar reduced thermal barriers and improving on the difficulties with non-integrated elements.

Further, additional embodiments may include a doped resistive element that is not directly integrated into a nozzle 50, for use primarily as a sensor in other applications. In such embodiments, engagement features, 66, 68 may not be required or applicable to such sensing applications.

The foregoing description of preferred and other embodiments is not intended to limit or restrict the scope or applicability of the inventive concepts conceived by the Applicants. It will be appreciated with the benefit of the present disclosure that features described above in accordance with any embodiment or aspect of the disclosed subject matter can be utilized, either alone or in combination, with any other described feature, in any other embodiment or aspect of the disclosed subject matter.

Further aspects of the invention are described in the following clauses:
Clause 1. A die nozzle, comprising:
   a base crystalline substrate having an undoped region;
   a resistive heating region of the base crystalline substrate comprising a doped crystalline material monolithically integrated in the base substrate;
   one or more engagement features formed into the base substrate forming a die interface surface; and
   electrical contacts in electrical communication with the resistive heating region.
Clause 2. The die nozzle of clause 1, wherein the one or more engagement features comprises a shoulder in a surface of the base substrate, the shoulder being recessed from the surface of the base substrate and being configured to engage a portion of a corresponding die.
Clause 3. The die nozzle of clause 1, wherein the one or more engagement features comprises a raised stand-off relative to a bottom surface of the base substrate, the stand-off being configured to engage a portion of a corresponding die.
Clause 4. The die nozzle of clause 1, wherein the die nozzle is a temperature sensor, wherein the resistive heating region has a resistance that varies with its temperature.
Clause 5. The die nozzle of clause 2 or 3, wherein the one or more engagement features includes at least one vacuum channel, the at least one vacuum channel being configured to pneumatically communicate a vacuum through the die nozzle to a portion of the die adjacent a surface of the base substrate.
Clause 6. The die nozzle of clause 1, wherein the base crystalline substrate comprises at least one of silicon (Si), crystalline silicon (c-Si), silicon carbide (SiC), diamond, silicon nitride, and allotropes of carbon.
Clause 7. The die nozzle of clause 1, wherein the resistive heating region has a coefficient of thermal expansion about the same as a coefficient of thermal expansion of the base crystalline substrate.
Clause 8. The die nozzle of clause 1, where the resistive heating region has a shape selected from one of: a plate shape, a serpentine shape, a ring shape, a spiral shape, and a segmented shape.
Clause 9. The die nozzle of clause 1, wherein the base substrate further comprises a conductive via electrically connected to the resistive heating region.
Clause 10. The die nozzle of clause 1, where in the base substrate further comprises an additional substrate.
Clause 11. The die nozzle of clause 1, further comprising cooling channels therein.
Clause 12. The die nozzle of clause 11, wherein the cooling channels are between the resistive heating region and the die interface surface.
Clause 13. The die nozzle of clause 11, wherein the resistive heating region is between the cooling channels and the die interface surface.
Clause 14. The die nozzle of clause 11, wherein the resistive heating region is offset from the die interface surface.
Clause 15. The die nozzle of clause 14, where the offset is from about 100 microns to about 5 mm.
Clause 16. The die nozzle of clause 1, further comprising a thermal isolation layer comprising an oxide, the resistive heating region being between the thermal isolation layer and the die interface surface.
Clause 17. The die nozzle of clause 16, further comprising cooling channels between the thermal isolation layer and the resistive heating region.
Clause 18. A method of manufacturing a nozzle with an integrated heater, the method comprising:
   providing a base substrate having an undoped crystalline material;
   doping the base substrate to form a monolithically integrated resistive heating region;
   forming one or more engagement features into the base substrate to form a die interface surface; and
   providing electrical contacts in electrical contact to the resistive heating region.
Clause 19. The method of clause 18, forming one or more vacuum channels in the base substrate connected to the die interface surface.
Clause 20. The method of clause 19, wherein forming the one or more engagement features comprising forming one or more recesses in a bottom surface of the nozzle.
Clause 21. The method of clause 18, wherein doping the base substrate comprises implant doping a dopant into the undoped crystalline material of the base substrate.
Clause 22. The method of clause 21, wherein the base substrate comprises at least one of silicon (Si), crystalline silicon (c-Si), silicon carbide (SiC), diamond, silicon nitride, and allotropes of carbon, and wherein the dopant comprises at least one of boron (B), phosphorous (P), nitrogen (N), or aluminum (Al).
Clause 23. The method of clause 18, further comprising: forming one or more cooling channels in the base substrate.
Clause 24. The method of clause 23, further comprising further comprising forming a thermal isolation layer such that that cooling channels are between the thermal isolation layer and the die interface surface.
Clause 25. The method of clause 19, further comprising:
   attaching the nozzle to a thermal compression bonding head having a heat exchanger and a vacuum source;
   placing the nozzle in thermal communication with the heat exchanger; and
   placing the one or more vacuum channels in communication with the vacuum source, the one or more vacuum channels being configured to draw a vacuum against a semiconductor die adjacent the die interface surface.
Clause 26. The method of clause 18, wherein providing the base substrate comprises forming the base substrate by bonding two or more intermediate substrates together.
Clause 27. The method of clause 26, wherein at least one of the intermediate substrates comprises a silicon-on-insulator (SOI) wafer substrate, the SOI wafer substrate having a buried oxide layer.
Clause 28. The method of clause 18, wherein doping the base substrate comprises doping through a patterned mask, the patterned mask having a shape selected from one of: a plate shape, a serpentine shape, a ring shape, a spiral shape, and a segmented shape.

## Claims

1. A die nozzle, comprising:
a base crystalline substrate having an undoped region;
a resistive heating region of the base crystalline substrate comprising a doped crystalline material monolithically integrated in the base substrate;
one or more engagement features formed into the base substrate forming a die interface surface; and
electrical contacts in electrical communication with the resistive heating region.

2. The die nozzle of claim 1, wherein the one or more engagement features comprises a shoulder in a surface of the base substrate, the shoulder being recessed from the surface of the base substrate and being configured to engage a portion of a corresponding die, or wherein the one or more engagement features comprises a raised stand-off relative to a bottom surface of the base substrate, the stand-off being configured to engage a portion of a corresponding die.

3. The die nozzle of claim 1 or 2, wherein the die nozzle is a temperature sensor, wherein the resistive heating region has a resistance that varies with its temperature.

4. The die nozzle of any one of claims 1-3, wherein the one or more engagement features includes at least one vacuum channel, the at least one vacuum channel being configured to pneumatically communicate a vacuum through the die nozzle to a portion of the die adjacent a surface of the base substrate.

5. The die nozzle of any one of claims 1-4, wherein the base crystalline substrate comprises at least one of silicon (Si), crystalline silicon (c-Si), silicon carbide (SiC), diamond, silicon nitride, and allotropes of carbon and/or wherein the resistive heating region has a coefficient of thermal expansion about the same as a coefficient of thermal expansion of the base crystalline substrate and/or wherein the resistive heating region has a shape selected from one of: a plate shape, a serpentine shape, a ring shape, a spiral shape, and a segmented shape.

6. The die nozzle of any one of claims 1-5, wherein the base substrate further comprises a conductive via electrically connected to the resistive heating region and/or wherein the base substrate further comprises an additional substrate.

7. The die nozzle of any one of claims 1-6, further comprising cooling channels therein, wherein the cooling channels are preferably between the resistive heating region and the die interface surface, and/or wherein the resistive heating region is preferably between the cooling channels and the die interface surface, and/or wherein the resistive heating region is offset from the die interface surface, wherein the offset is preferably from about 100 microns to about 5 mm.

8. The die nozzle of any one of claims 1-7, further comprising a thermal isolation layer comprising an oxide, the resistive heating region being between the thermal isolation layer and the die interface surface, preferably further comprising cooling channels between the thermal isolation layer and the resistive heating region.

9. A method of manufacturing a nozzle with an integrated heater, the method comprising:
providing a base substrate having an undoped crystalline material;
doping the base substrate to form a monolithically integrated resistive heating region;
forming one or more engagement features into the base substrate to form a die interface surface; and
providing electrical contacts in electrical contact to the resistive heating region.

10. The method of claim 9, forming one or more vacuum channels in the base substrate connected to the die interface surface, wherein forming the one or more engagement features preferably comprises forming one or more recesses in a bottom surface of the nozzle.

11. The method of claim 9 or 10, wherein doping the base substrate comprises implant doping a dopant into the undoped crystalline material of the base substrate, wherein the base substrate preferably comprises at least one of silicon (Si), crystalline silicon (c-Si), silicon carbide (SiC), diamond, silicon nitride, and allotropes of carbon, and wherein the dopant preferably comprises at least one of boron (B), phosphorous (P), nitrogen (N), or aluminum (Al).

12. The method of any one of claims 9-11, further comprising: forming one or more cooling channels in the base substrate, preferably further comprising forming a thermal isolation layer such that the cooling channels are between the thermal isolation layer and the die interface surface.

13. The method of any one of claims 10-12, further comprising:
attaching the nozzle to a thermal compression bonding head having a heat exchanger and a vacuum source;
placing the nozzle in thermal communication with the heat exchanger; and
placing the one or more vacuum channels in communication with the vacuum source, the one or more vacuum channels being configured to draw a vacuum against a semiconductor die adjacent the die interface surface.

14. The method of any one of claims 9-13, wherein providing the base substrate comprises forming the base substrate by bonding two or more intermediate substrates together, wherein preferably at least one of the intermediate substrates comprises a silicon-on-insulator (SOI) wafer substrate, the SOI wafer substrate having a buried oxide layer.

15. The method of any one of claims 9-14, wherein doping the base substrate comprises doping through a patterned mask, the patterned mask having a shape selected from one of: a plate shape, a serpentine shape, a ring shape, a spiral shape, and a segmented shape.
